# EUROPÄISCHE PATENTSCHRIFT

(11) **EP 1 573 890 B1**
(45) Veröffentlichungstag und Bekanntmachung des Hinweises auf die Patenterteilung: **28.06.2006**
(21) Anmeldenummer: 03772347.5
(22) Anmeldetag: 20.11.2003
(51) Int. Cl.: H02M 7/00, H05K 7/14

(54) **FREQUENZUMFORMER MIT LÜFTERKÜHLUNG**
FREQUENCY CONVERTER WITH FAN COOLING
CONVERTISSEUR DE FREQUENCE A REFROIDISSEMENT PAR AIR

(30) Priorität: 16.12.2002 DE 10258765
(43) Veröffentlichungstag der Anmeldung: 14.09.2005
(73) Patentinhaber: Wacker Construction Equipment AG, 80809 München (DE)
(72) Erfinder: MEYER, Matthias, 85356 Freising (DE); GLANZ, Christian, 85221 Dachau (DE)
(74) Vertreter: Hoffmann, Jörg Peter
(86) Internationale Anmeldenummer: PCT/EP2003/013046
(87) Internationale Veröffentlichungsnummer: WO 2004/055965

(56) Entgegenhaltungen:
- EP-A- 0 854 565
- DE-A- 19 900 348
- US-A- 5 170 336

## Beschreibung

Die Erfindung betrifft einen Frequenzumformer gemäß dem Oberbegriff des Anspruchs 1, insbesondere für Baustellengeräte.

An Baustellen steht bei der Stromversorgung in der Regel ein Netzstrom mit einer Frequenz von 50 Hz und einer Spannung von 230 V, gelegentlich auch 400 V, zur Verfügung. Dieser lokal vorhandene Baustellenstrom wird durch die von der Erfindung betroffenen Frequenzumformer beispielsweise in einen Drehstrom mit 200 Hz und einer Schutzkleinspannung von 42 V umgewandelt, wobei die Schutzkleinspannung benötigt wird, um das Bedienungspersonal in einer z.B. feuchten Umgebung vor elektrischer Gefährdung zu schützen.

Bei bekannten Geräten dieser Art werden ein Trenntransformator und eine Umformerplatine verwendet, die bedingt durch ihre Verlustleistung Wärme entstehen lassen, die abgeführt werden muß, was durch die Verwendung von Kühlkörpern mit ausreichend großer Kühlfläche, große Gehäuse bzw. Überdimensionierung des Trenntransformators erreicht wird. Diese Maßnahmen zur Wärmeabfuhr sind kostenintensiv und verursachen mehr Gewicht. Die bekannten Geräte können außenliegende Kühlrippen aufweisen, die sich mit der Zeit durch Schmutz und auch mit Beton zusetzen können, was die Wärmeabfuhr immer mehr beeinträchtigt.

Aus der EP-A-0 854 565 ist ein Frequenzumformer mit einer von einem Gehäuse umgebenen Umformereinrichtung zum Wandeln einer elektrischen Stromfrequenz bekannt. Das Gehäuse weist eine einen Platinenraum für die Umformereinrichtung umgebende Umformeraufnahme auf, sowie einen sich an die Umformeraufnahme anschließenden, als Kühlungsbereich dienenden Gehäuseabschnitt, in dessen Innerem Kühlluftkanäle und ein zur Förderung von Kühlluft durch die Kühlluftkanäle geeigneter Lüfter angeordnet sind.

Der Erfindung liegt die Aufgabe zugrunde, einen luftgekühlten Frequenzumformer der eingangs geschilderten Art derart zu gestalten, dass die konstruktiv vorgegebene Kühlleistung auch bei längerem Gebrauch erhalten bleibt, zugleich eine kleinere, kompaktere Bauform ermöglicht wird, dass sein Gewicht und die Fertigungskosten reduziert werden, und dass als weiterer Beitrag zur Kostensenkung eine vorgegebene Basiskonstruktion für Geräte unterschiedlicher Leistungsklassen verwendbar ist.

Zur Lösung dieser Aufgabe besteht die Erfindung gemäß dem kennzeichnenden Teil des Anspruchs 1 darin, dass das Gehäuse eine einen Platinenraum für die Umformereinrichtung umgebende Umformeraufnahme, und einen sich an die Umformeraufnahme anschließenden, als Kühlungsbereich dienenden Gehäuseabschnitt, in dessen Innerem Kühlluftkanäle und ein zur Förderung von Kühlluft durch die Kühlluftkanäle geeigneter Lüfter angeordnet sind, aufweist, sowie im Kühlungsbereich ein äußeres, ringförmiges, erstes Ring- bzw. Strangprofil, in Bezug auf dessen Achse weitere ringförmige Strangprofile zueinander derart ausgerichtet sind, dass sie einander unter Bildung von Ringräumen mit Abstand quer zur Achsrichtung umgeben und die innerhalb des ersten Strangprofils angeordneten Ring- bzw. Strangprofile unter Bildung einer Luftumlenkung mit einem axialen Abstand von der Umformeraufnahme enden.

Durch die erfindungsgemäße Gestaltung werden Gehäuse und Kühlung zu einer kompakten Einheit zusammengefasst, wobei durch die aktive Luftkühlung mittels des Lüfters bzw. Ventilators die erforderlichen Kühlflächen reduziert werden können und auf äußere, zur Verschmutzung und damit zur Reduzierung der Kühlleistung neigende Kühlrippen verzichtet werden kann.

Bei einer vorteilhaften Weiterentwicklung der Erfindung weist der Kühlungsbereich einen an die Kühlluftkanäle angrenzenden Traforaum auf, zur Aufnahme eines Trenntransformators zum Erzeugen einer von einer Netzspannung abweichenden Ausgangsspannung. Dadurch lassen sich der Trenntransformator und die Umformereinrichtung zu einer Einheit als Frequenzumformer kombinieren, wobei der Trenntransformator zur optimalen Kühlung in dem Kühlungsbereich selbst angeordnet ist. Der Trenntransformator kann zum Erzeugen einer Schutzkleinspannung, z. B. in Höhe von 42 V, dienen. Selbstverständlich ist es auch möglich, durch ihn eine Ausgangsspannung mit einem höheren Wert als der Netzspannung zu erzeugen.

Bei einer besonders vorteilhaften Ausgestaltung ist innerhalb des ersten Strangprofils und koaxial zu diesem in der Luftumlenkung zwischen den weiteren Strangprofilen und der Umformeraufnahme der Lüfter derart angeordnet, dass er geeignet ist, einen Kühlluftstrom über einen der Ringräume anzusaugen und über einen anderen Ringraum nach dem Gegenstromprinzip auszustoßen.

Durch die Verwendung von Strangprofilen als Ringprofile wird ein besonders einfacher und kostengünstiger, sowie äußerst kompakter Aufbau des Geräts ermöglicht. Dabei kann in sehr zweckmäßiger Weiterbildung das dem ersten Strangprofil benachbarte Strangprofil einen ringförmigen Traforaum umschließen, der nach innen durch ein drittes Strangprofil begrenzt wird. Vorzugsweise enthält der Traforaum einen Ringkerntransformatorensatz.

Nach einer besonders zweckmäßigen Ausführungsform sind die Strangprofile passend abgelängte Aluminiumstrangpreßprofile. Je nach Dimensionierung des Trenntransformators kann die Bauform des Gehäuses im Kühlungsbereich durch geeignete Wahl der Länge der Strangprofile dem Platzbedarf des Transformators angepaßt werden.

Eine weitere, sehr vorteilhafte Ausgestaltung besteht darin, dass das dritte Ring- bzw. Strangprofil zur Bildung eines Kühlkörpers aus einem Außen- und einem Innenring besteht, wobei im Bereich zwischen Außen- und Innenring Kühlrippen angeordnet sind, die zusammen mit Außen- und Innenring einen der Kühlluftkanäle bilden.

Eine sehr einfache Montage wird dadurch ermöglicht, dass nach einem bevorzugten Merkmal das äußere, erste Strangprofil nach den Prinzip Nut-Feder mit dem benachbarten Strangprofil in Eingriff steht.

Weitere vorteilhafte und zweckmäßige Ausgestaltungen der Erfindung ergeben sich aus der nachfolgenden Beschreibung eines Ausführungsbeispiels in Verbindung mit den Unteransprüchen.

Anhand des in den Figuren dargestellten Ausführungsbeispiels der Erfindung in Form eines Frequenzumformers mit einem Trenntransformator zur Erzeugung einer Schutzkleinspannung und Umluftkühlung wird die Erfindung näher erläutert.

### Es zeigen:

- **Fig. 1**: eine perspektivische Seitenansicht des erfindungsgemäßen Geräts, bestehend äus Schutzschlitten und Gerätekörper,
- **Fig. 2**: eine Ansicht in Richtung des Pfeils II in Fig. 1 in etwas größerem Maßstab.
- **Fig. 3**: einen Längsschnitt durch das Gerät nach der Linie III-III in Fig. 2 in weiter vergrößertem Maßstab,
- **Fig. 4**: eine der Fig. 3 ähnliche Darstellung des montierten Gehäuses des Gerätekörpers ohne Umformerplatine und Trenntransformator,
- **Fig. 5**: eine perspektivische Ansicht des Grundkörpers,
- **Fig. 6**: einen Querschnitt durch das zur Bildung des den Transformator aufnehmenden Gehäuseabschnitts dienende Außenringprofil,

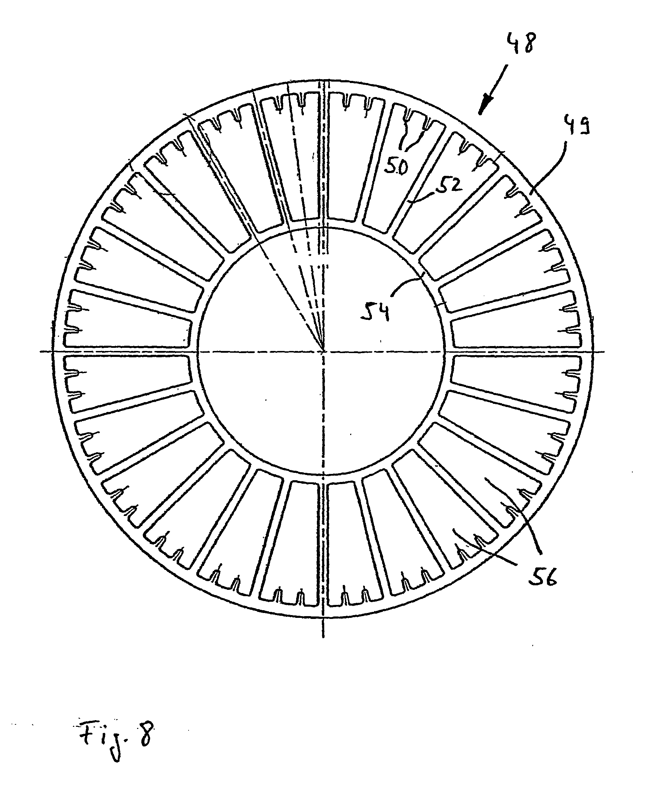

- **Fig. 7**: einen Querschnitt durch das zur Bildung der Luftführung dienende Grundkörperprofil und
- **Fig. 8**: einen Querschnitt durch das zur Bildung des Kühlkörpers dienende Strangprofil.

Ein erfindungsgemäßer Frequenzumformer weist eine Umformereinrichtung zum Wandeln der elektrischen Stromfrequenz von einer Netzfrequenz in einen elektrischen Strom mit höherer Frequenz auf. Weiterhin ist als Bestandteil des Frequenzumformers ein Trenntransformator vorgesehen, mit dem die Netzspannung von beispielsweise 230 V oder 400 V in eine niedrigere Spannung, z. B. 42 V, transformiert wird, um die mit dem Frequenzumformer oder einem daran angeschlossenen Baustellengerät, wie z. B. einem Innenrüttler zur Betonverdichtung, arbeitende Person nicht durch hohe elektrische Spannungen zu gefährden.

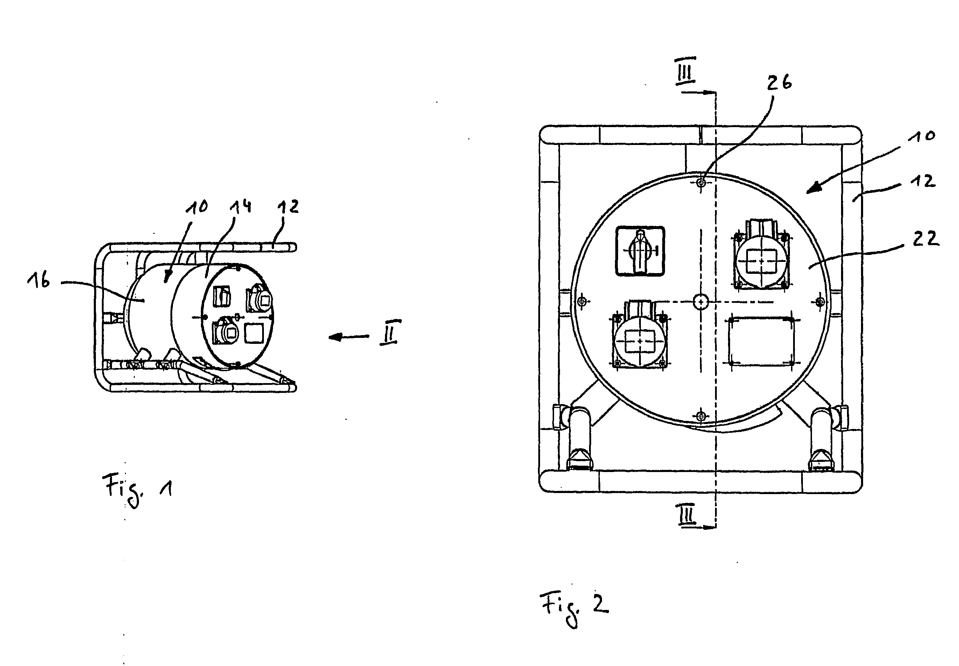

Wie die Fig. 1 zeigt, besteht das erfindungsgemäße Gerät aus dem eigentlichen, die elektrischen Einrichtungen und deren Peripherie enthaltenden Gerätekörper 10 und einer rahmenartigen, den Gerätekörper 10 nach allen Seiten abschirmenden Schutzschlitten 12, mit dem der Gerätekörper 10 über mehrere Anschlusspunkte lösbar verbunden ist.

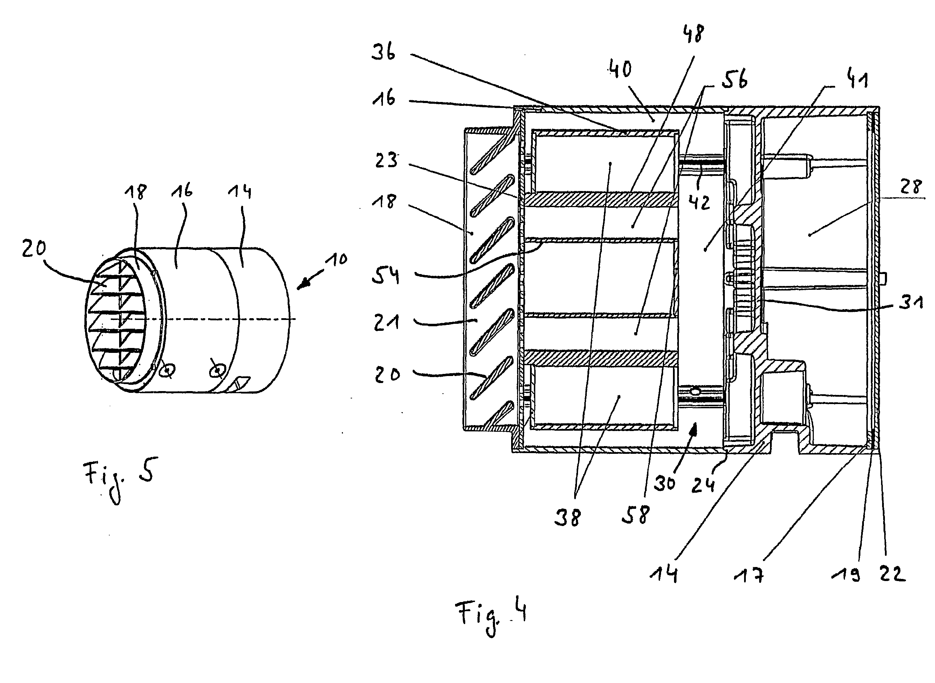

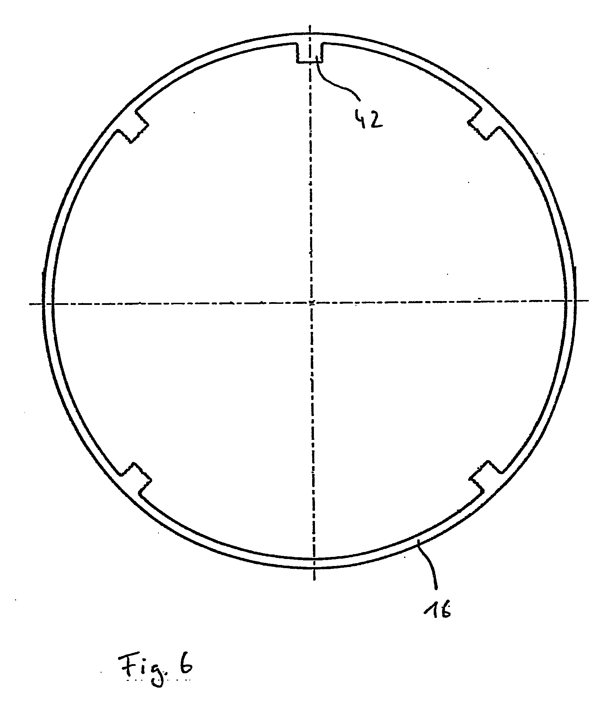

Der Gerätekörper 10 weist - wie die Fig. 2 bis 5 zeigen - eine im wesentlichen zylindrische Gestalt auf und ist von einem Gehäuse umschlossen, das sich zusammensetzt aus einer aus Aluminium gegossenen Umformeraufnahme 14 und einem Außenringprofil 16, das einen der aktiven Luftkühlung dienenden Geräteteil umschließt, der an der Stirnseite durch einen Deckel 18 abgeschlossen ist. Der Deckel 18 ist mit durch Rippen 20 vor Regen geschützten Luftdurchtrittsöffnungen 21 versehen, während die Umformeraufnahme 14 von einem Stützring 17, einer Dichtung 19 und einer Frontplatte 22 abgeschlossen wird, wie in Fig. 4 gezeigt. Hinter dem Deckel 18 befindet sich eine Schlitzscheibe 23 und gegebenenfalls ein Luftfilter. Die Umformeraufnahme 14 und das Außenringprofil 16 weisen den gleichen Außendurchmesser auf und können an ihrer Verbindungsstelle 24 in axialer Richtung ineinander gesteckt und durch geeignete Schraubverbindungen in dieser Lage gesichert werden, wie in Fig. 2 bei 26 gezeigt.

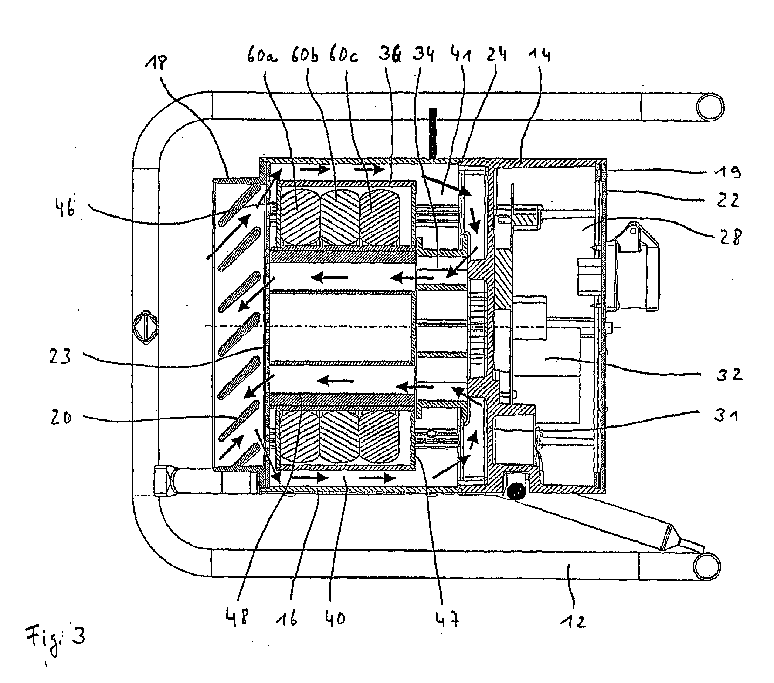

Wie die Fig. 3 und 4 deutlich zeigen, ist der innerhalb der Umformeraufnahme 14 ausgebildete Platinenraum 28 vollständig von dem sich in diesen Figuren nach links anschließenden, nach außen durch das Außenringprofil 16 und den Deckel 18 begrenzten Transformatoren- und Kühlungsbereich 30 getrennt. Der Platinenraum 28 nimmt die elektrischen Schaltungen der Umformereinrichtung auf. Die dort untergebrachte Umformerplatine 32 mit Leistungsmodul ist zu einer Einheit vergossen und austauschbar. Eine dem Transformatoren- und Kühlungsbereich 30 zugewandte Stirnwand bzw. Trennwand 31 der Umformeraufnahme 14 ist zum Einbau eines wechselstrombetriebenen Ventilators bzw. Lüfters 34 vorbereitet, dessen Luftführung in Fig. 3 durch Pfeile dargestellt ist und nachfolgend noch genauer beschrieben wird.

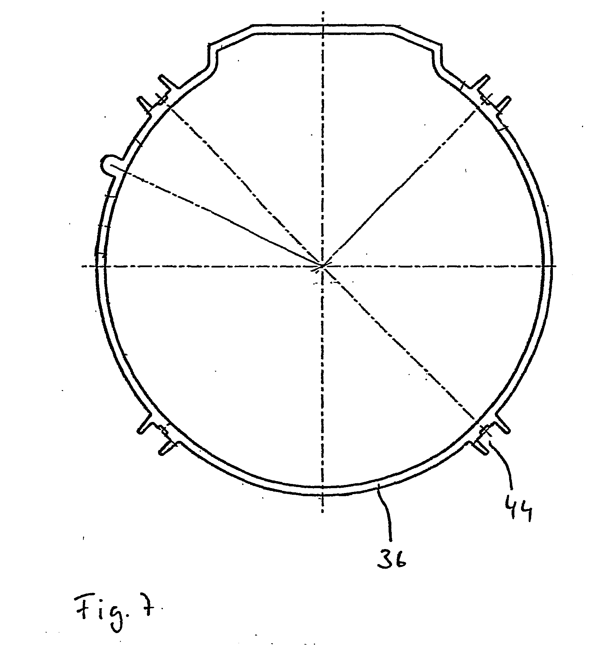

Das mit der z. B. in einem Aluminiumgießverfahren hergestellten Umformeraufnahme 14 zentrierte Außenringprofil 16 (Fig. 6) ist nach dem Prinzip Nut-Feder mit einem ebenfalls ringförmigen Grundkörperprofil 36 verbindbar, das einen Traforaum 38 radial auswärts begrenzt. Dabei wird ein radialer Abstand von der Innenfläche des Außenringprofils 16 eingehalten, so dass ein als Kühlluftkanal dienender ringförmiger Lufteinlaßkanal 40 (Ringraum) gebildet wird, der sich vom Deckel 18 bis zu dem als Luftumlenkung 41 dienenden und den Lüfter 34 aufnehmenden Bereich zwischen Traforaum 38 und Platinenraum 28 in axialer Richtung erstreckt. Die Nut-Feder-Verbindung besteht aus angeformten Federn 42 an der Innenseite des Außenringprofils 16 und diesen zugeordneten, nutartigen Kanälen 44 an der Außenseite des Grundkörperprofils 36.

In Richtung auf den Deckel 18 und in Richtung auf die Luftumlenkung 41 wird der vom Grundkörperprofil 36 umschlossene Traforaum 38 durch jeweils einen ringförmigen Deckel 46 bzw. 47 abgeschlossen, die ihrerseits die Zentrierung eines Kühlerprofils 48 (Fig. 8) gestatten. Das Kühlerprofil 48 begrenzt mit seiner an einem Außenring 49 ausgebildeten Außenfläche den Traforaum 38 und ist an der Innenfläche des Außenrings 49 mit teils großflächigen Rippen 50 und 52 versehen. Die großflächigen Rippen 52 sind mit einem Innenring 54 einstückig verbunden, durch den ein vom Lüfter 34 zum Deckel 18 mit den Durchtrittsöffnungen 18 verlaufender Luftauslaßkanal 56 radial einwärts begrenzt wird. Streng genommen besteht der Luftauslasskanal 56 aus vielen Einzelkanälen, die jeweils durch den Außenring 49, den Innenring 54 und seitlich durch die Rippen 52 begrenzt sind, wie besonders gut in Fig. 8 erkennbar.

Der vom Innenring 54 umschlossene Raum wird an seiner dem Lüfter 34 zugewandten Seite durch einen Deckel 58 abgeschlossen.

Im Traforaum 38 ist ein aus drei vergossenen Ringkernen 60a, 60b und 60c bestehender Trafosatz gekapselt angeordnet. Der die Ringkerne 60a, 60b und 60c aufweisende Trenntransformator ist somit vollständig zwischen dem Grundkörperprofil 36 und dem Kühlerprofil 48 ringförmig angeordnet. Sowohl auf der radialen Außenseite über den Lufteinlasskanal 40 als auch auf der radialen Innenseite über den Luftauslasskanal 56 strömt Kühlluft an dem Trenntransformator vorbei und bewirkt somit eine wirksame Kühlung.

Da die Kühlung außerdem an der Trennwand 31 vorbei geführt wird, wird auch die den Platinenraum 28 abschließende Trennwand 31 gekühlt. Die auf der Rückseite der Trennwand 31 befestigten, wärmeerzeugenden Einrichtungen der Umformereinrichtung auf der Umformerplatine 32 erfahren somit ebenfalls eine wirksame Kühlung.

Durch die Verwendung von Aluminium-Strangprofilen lässt sich das Gehäuse des erfindungsgemäßen Frequenzumformers sehr leicht aufbauen. Insbesondere ist es einfach möglich, durch Verändern der Länge der Strangprofile die Länge und damit Größe des Gehäuses zu verändern, um es an unterschiedliche Baugrößen von Umformereinrichtungen oder Trenntransformatoren anzupassen oder um gegebenenfalls unterschiedliche Kühlungswünsche zu realisieren.

Anhand der Figuren wurde eine bevorzugte Ausführungsform der Erfindung detailliert erläutert. Selbstverständlich ist es im Rahmen der Erfindung auch möglich, von der bisher beschriebenen konkreten Ausgestaltung abzuweichen. So ist es, zum Beispiel, ohne Weiteres denkbar, den Kühlluftstrom entgegen zu der in Fig. 3 gezeigten und oben erläuterten Strömungsrichtung zu führen. Sowohl Richtung als auch Verlauf des Kühlluftstroms lassen sich je nach Anforderung variieren. Je nach Ausgestaltung ist dies allein schon dadurch möglich, dass die Gebläserichtung des Lüfters umgekehrt wird.

Weiterhin ist es möglich, den Lüfter auch an anderer Stelle als in dem Luftumlenkungsbereich anzuordnen. So ist es, zum Beispiel, denkbar, den Lüfter am Ende der Kühlluftkanäle anzuordnen, so dass die Kühlluft ausschließlich im Saugbetrieb durch den Frequenzumformer gezogen würde. Umgekehrt könnte der Lüfter auch stromauf von den Kühlluftkanälen des Frequenzumformers angeordnet sein.

## Patentansprüche

1. Frequenzumformer, insbesondere für mit einem elektrischen Strom mit höherer Frequenz als Netzfrequenz betriebene Baustellengeräte, mit
- einer Umformereinrichtung zum Wandeln der elektrischen Stromfrequenz;
- einem Trenntransformator (60a, 60b, 60c) zum Erzeugen einer von einer Netzspannung abweichenden Ausgangsspanung; und mit
- einem die Umformereinrichtung und den Trenntransformator (60a, 60b, 60c) umgebenden Gehäuse;
wobei das Gehäuse aufweist:
- eine einen Platinenraum (28) für die Umformereinrichtung umgebende Umformeraufnahme (14);
- einen sich an die Umformeraufnahme (14) anschließenden, als Kühlungsbereich (30) dienenden Gehäuseabschnitt, in dessen Innerem Kühlluftkanäle (40, 41, 56) und ein zur Förderung von Kühlluft durch die Kühlluftkanäle geeigneter Lüfter (34) angeordnet sind;
- eine die Umformeraufnahme (14) und den Kühlungsbereich (30) thermisch miteinander koppelnde Trennwand (31);
- im Kühlungsbereich (30) einen an die Kühlluftkanäle (40, 41, 56) angrenzenden Traforaum (38) zur Aufnahme des Trenntransformators (60a, 60b, 60c); **dadurch gekennzeichnet, dass** das Gehäuse aufweist :
- im Kühlungsbereich (30) ein äußeres, erstes Ringprofil (16);
- ein mit radialem Abstand in dem ersten Ringprofil (16) angeordnetes zweites Ringprofil (36), das den Traforaum (38) außen umschließt;
- einen als Kühlluftkanal (40) dienenden Ringraum zwischen dem äußeren, ersten Ringprofil (16) und dem zweiten Ringprofil (36); und
- ein drittes Ringprofil (48), das den Traforaum (38) radial innen begrenzt und innerhalb dem ein Kühlluftkanal (56) gebildet ist;
wobei
- die innerhalb des ersten Ringprofils (16) angeordneten Ringprofile (36, 48) sich derart axial erstrecken, dass sie mit einem axialen Abstand von der Trennwand (31) zur Umformeraufnahme (14) enden, derart, dass ein als Kühlluftkanal dienender Luftumlenkungsbereich (41) gebildet wird, der an die Trennwand (31) angrenzt und den zwischen dem ersten Ringprofil (16) und dem zweiten Ringprofil (36) gebildeten Kühlluftkanal (40) mit dem innerhalb dem dritten Ringprofil (48) gebildeten Kühlluftkanal (56) verbindet.

2. Frequenzumformer nach Anspruch 1, **dadurch gekennzeichnet, dass** innerhalb des ersten Ringprofils (16) und koaxial zu diesem der Lüfter (34) derart angeordnet ist, dass er geeignet ist, einen Kühlluftstrom über einen der Kühlluftkanäle (40) anzusaugen, in dem Luftumlenkungsbereich (41) an wenigstens einem Teil der Trennwand (31) vorbeizuführen und über einen anderen Kühlluftkanal (56) nach dem Gegenstromprinzip auszustoßen.

3. Frequenzumformer nach Anspruch 2, **dadurch gekennzeichnet, dass** der Lüfter (34) in dem Luftumlenkungsbereich (41) angeordnet ist.

4. Frequenzumformer nach einem der Ansprüche 1 bis 3, **dadurch gekennzeichnet, dass** das dritte Ringprofil (48) zur Bildung eines Kühlkörpers aus einem Außen- (49) und einem Innenring (54) besteht, wobei im Bereich zwischen Außen- und Innenring Kühlrippen (50, 52) angeordnet sind, die eine Wandung eines der als Kühlluftkanal dienenden Ringräume (56) bilden.

5. Frequenzumformer nach Anspruch 4, **dadurch gekennzeichnet, dass** ein Teil (52) der Kühlrippen den Außen- und den Innenring (49, 54) miteinander verbindet und zwischen diesen Kühlrippen (52) am Außenring (49) in radialer Richtung frei nach innen vorspringende Rippen (50) angeordnet sind.

6. Frequenzumformer nach einem der Ansprüche 1 bis 5, **dadurch gekennzeichnet, dass** das äußere, erste Ringprofil (16) nach den Prinzip Nut-Feder (42, 44) mit dem benachbarten Ringprofil (36) in Eingriff steht.

7. Frequenzumformer nach einem der Ansprüche 1 bis 6, **dadurch gekennzeichnet, dass** der Traforaum (38) in axialer Richtung durch ringförmige, sich zwischen der äußeren Begrenzung durch das zweite Ringprofil (36) und der inneren Begrenzung durch das dritte Ringprofil (48) des Traforaums erstreckende Deckel (46, 47) abschließbar ist.

8. Frequenzumformer nach einem der Ansprüche 1 bis 7, **dadurch gekennzeichnet, dass** der Traforaum (38) einen Ringkerntransformatorensatz (60a, 60b, 60c) enthält.

9. Frequenzumformer nach einem der Ansprüche 1 bis 8, **dadurch gekennzeichnet, dass** die Ringprofile Strangprofile sind.

10. Frequenzumformer nach Anspruch 9, **dadurch gekennzeichnet, dass** die Strangprofile (16, 36, 48) passend abgelängte Aluminiumstrangpreßprofile sind.

11. Frequenzumformer nach Anspruch 1, **dadurch gekennzeichnet, dass** das äußere, erste Ringprofil (16) zentrierend mit der Umformeraufnahme (14) verbunden ist.

12. Frequenzumformer nach einem der Ansprüche 1 bis 11, **dadurch gekennzeichnet, dass** die Umformeraufnahme (14) im wesentlichen aus einem Aluminiumgussteil besteht.

13. Frequenzumformer nach einem der Ansprüche 1 bis 12, **dadurch gekennzeichnet, dass** das dritte Ringprofil (48) durch die den Traforaum (38) abschließenden Deckel (46, 47) gegenüber dem dem ersten Ringprofil (16) benachbarten zweiten Ringprofil (36) zentriert ist.

14. Frequenzumformer nach Anspruch 2, **dadurch gekennzeichnet, dass** der Lüfter (34) derart angeordnet ist, dass er über den dem ersten, äußeren Ringprofil (16) benachbarten Kühlluftkanal (40) Kühlluft ansaugt und diese über den vom Traforaum (38) umschlossenen Kühlluftkanal (56) wieder nach außen abführt.

15. Frequenzumformer nach einem der Ansprüche 1 bis 14, **dadurch gekennzeichnet, dass** der Kühlungsbereich (30) in axialer Richtung einerseits von der Trennwand (31) der Umformeraufnahme (14) und andererseits von einem mit Luftdurchtrittsöffnungen (21) versehenen Deckel (18) abgeschlossen ist.

16. Frequenzumformer nach einem der Ansprüche 1 bis 15, **dadurch gekennzeichnet, dass** der Platinenraum (28) einerseits durch die Trennwand (31) der Umformeraufnahme (14) und andererseits durch eine Frontplatte (22) abgeschlossen ist.

17. Frequenzumformer nach einem der Ansprüche 1 bis 16, **dadurch gekenzeichnet, dass** eine im Platinenraum untergebrachte Umformerplatine (32) mit einem Leistungsmodul vergossen und austauschbar ist.

## Claims

1. Frequency converter in particular for building site devices which are operated with an electrical current which is at a higher frequency than mains frequency, comprising
- a converting device for converting the electrical current frequency;
- an isolating transformer (60a, 60b, 60c) for generating an output voltage which differs from a mains voltage; and comprising
- a housing which surrounds the converting device and the isolating transformer (60a, 60b, 60c);
wherein the housing comprises
- a transformer receiving device (14) which surrounds a plate chamber (28) for the converting device;
- a housing section which is adjacent to the transformer receiving device (14) and acts as a cooling region (30), cooling air channels (40, 41, 56) and a ventilator (34) which is suitable for conveying cooling air through the cooling air channels are disposed inside the housing section;
- a separating wall (31) which thermally couples the transformer receiving device (14) and the cooling region (30) to each other;
- in the cooling region (30) a transformer chamber (38) which is adjacent to the cooling air channels (40, 41, 56) for receiving the isolating transformer (60a, 60b, 60c); **characterised in that** the housing comprises:
- in the cooling region (30) an outer first annular profile (16);
- a second annular profile (36) which is disposed with a radial spaced disposition in the first annular profile (16) and which surrounds the transformer chamber (38) on the outside;
- an annular chamber which acts as a cooling air channel (40) between the outer, first annular profile (16) and the second annular profile (36); and
- a third annular profile (48) which radially inwardly defines the transformer chamber (38) and forms therein a cooling air channel (56);
wherein
- the annular profiles (36, 48) disposed inside the first annular profile (16) extend axially in such a manner that they terminate with an axial spaced disposition from the separating wall (31) with respect to the transformer receiving device (14) in such a manner that an air-deflecting region (41) is formed which acts as a cooling air channel and is adjacent to the separating wall (31) and connects the cooling air channel (40) formed between the first annular profile (16) and the second annular profile (36) to the cooling air channel (56) formed inside the third annular profile (48).

2. Frequency converter as claimed in claim 1, **characterised in that** inside the first annular profile (16) and coaxial thereto the ventilator (34) is disposed in such a manner that it is suitable to draw in a cooling air flow via one of the cooling air channels (40), to guide said cooling air flow in the air-deflecting region (41) past at least a portion of the separating wall (31) and to discharge the said air flow via another cooling air channel (56) in accordance with the counter flow principle.

3. Frequency converter as claimed in claim 2, **characterised in that** the ventilator (34) is disposed in the air-deflecting region (41).

4. Frequency converter as claimed in any one of claims 1 to 3, **characterised in that** the third annular profile (48) for forming a cooling body consists of an outer ring (49) and an inner ring (54), wherein cooling ribs (50, 52) are disposed in the region between the outer and the inner ring and said ribs form a wall of one of the annular spaces (56) which serve as a cooling air channel.

5. Frequency converter as claimed in claim 4, **characterised in that** a portion (52) of the cooling ribs connects the outer and the inner ring (49, 54) to each other and ribs (50) which protrude freely inwards in the radial direction are disposed between these cooling ribs (52) on the outer ring (49).

6. Frequency converter as claimed in any one of claims 1 to 5, **characterised in that** the outer, first annular profile (16) is engaged with the adjacent annular profile (36) in accordance with the principle of tongue and groove (42, 44).

7. Frequency converter as claimed in any one of claims 1 to 6, **characterised in that** the transformer chamber (38) can be closed in the axial direction by annular covers (46, 47) which extend between the outer limitation through the second annular profile (36) and the inner limitation through the third annular profile (48) of the transformer chamber.

8. Frequency converter as claimed in any one of claims 1 to 7, **characterised in that** the transformer chamber (38) contains a set of toroidal transformers (60a, 60b, 60c).

9. Frequency converter as claimed in any one of claims 1 to 8, **characterised in that** the annular profiles are extruded profiles.

10. Frequency converter as claimed in claim 9, **characterised in that** the extruded profiles (16, 36, 48) are aluminium extruded sections which have been cut to corresponding lengths.

11. Frequency converter as claimed in claim 1, **characterised in that** the outer, first annular profile (16) is connected in a centring manner with the transformer receiving device (14).

12. Frequency converter as claimed in any one of claims 1 to 11, **characterised in that** the transformer receiving device (14) consists substantially of an aluminium cast part.

13. Frequency converter as claimed in any one of claims 1 to 12, **characterised in that** the third annular profile (48) is centred by the covers (46, 47), which close the transformer chamber (38), with respect to the second annular profile (36) which is adjacent to the first annular profile (16).

14. Frequency converter as claimed in claim 2, **characterised in that** the ventilator (34) is disposed in such a manner that it draws in cooling air via the cooling air channel (40) which is adjacent to the first, outer annular profile (16) and then discharges this air outwards via the cooling air channel (56) which is surrounded by the transformer chamber (38).

15. Frequency converter as claimed in any one of claims 1 to 14, **characterised in that** the cooling region (30) is closed in an axial direction on one hand by the separating wall (31) of the transformer receiving device (14) and on the other hand by a cover (18) which is provided with air orifices (21).

16. Frequency converter as claimed in any one of claims 1 to 15, **characterised in that** the plate chamber (28) is closed on the one hand by the separating wall (31) of the transformer receiving device (14) and on the other hand by a front plate (22).

17. Frequency converter as claimed in any one of claims 1 to 16, **characterised in that** a former plate (32) disposed in the plate chamber is cast with a power module and is replaceable.

## Revendications

1. Convertisseur de fréquence, en particulier pour des engins de chantier exploités avec un courant électrique avec une fréquence supérieure comme fréquence de réseau, comprenant :
- un dispositif convertisseur pour la conversation de la fréquence du courant électrique ;
- un transformateur de séparation (60a, 60b, 60c) pour générer une tension de sortie différente d'une tension de réseau ; et avec
- un boîtier entourant le dispositif convertisseur et le transformateur de séparation (60a, 60b, 60c) ;
le boîtier présentant :
- un logement de convertisseur (14) entourant un espace de platine (28) pour le dispositif convertisseur ;
- une partie de boîtier servant de zone de refroidissement (30) et se raccordant au logement de convertisseur (14), dans l'espace intérieur de laquelle sont disposés des canaux d'air de refroidissement (40, 41, 56) et un ventilateur (34) approprié pour le transport d'air de refroidissement à travers les canaux d'air de refroidissement ;
- une paroi de séparation (31) couplant thermiquement entre le logement de convertisseur (14) et la zone de refroidissement (30) ;
- dans la zone de refroidissement (30) un espace du transformateur (38) contigu aux canaux d'air de refroidissement (40, 41, 56) pour le logement du transformateur de séparation (60a, 60b, 60c) ; **caractérisé en ce que** le boîtier présente :
- dans la zone de refroidissement (30) un premier profilé annulaire (16) extérieur ;
- un second profilé annulaire (36) disposé à la distance radiale dans le premier profilé annulaire (16), qui entoure l'espace de transformateur (38) à l'extérieur ;
- un espace annulaire servant de canal d'air de refroidissement (40) entre le premier profilé annulaire (16) extérieur et le second profilé annulaire (36) ; et
- un troisième profilé annulaire (48), qui délimite l'espace du transformateur (38) radialement à l'intérieur et à l'intérieur duquel est formé un canal d'air de refroidissement (56) ;
- les profilés annulaires (36, 48) disposés à l'intérieur du premier profilé annulaire (16) s'étendant axialement de telle sorte qu'ils se terminent par une distance axiale de la paroi de séparation (31) pour le logement du convertisseur (14) de telle sorte qu'une zone d'évacuation d'air (41) servant de canal d'air de refroidissement est formée, laquelle zone est contiguë à la paroi de séparation (31) et relie le canal d'air de refroidissement (40) formé entre le premier profilé annulaire (16) et le second profilé annulaire (36) au canal d'air de refroidissement (56) formé à l'intérieur du troisième profilé annulaire (48).

2. Convertisseur de fréquence selon la revendication 1, **caractérisé en ce que** le ventilateur (34) est disposé à l'intérieur du premier profilé annulaire (16) et de façon coaxiale par rapport à celui-ci de telle sorte qu'il est approprié pour aspirer un flux d'air de refroidissement par l'un des canaux d'air de refroidissement (40), de le guider dans la zone de déviation d'air (41) en le faisant passer devant au moins une partie de la paroi de séparation (31) et en l'expulsant par un autre canal d'air de refroidissement (56) selon le principe de contre-courant.

3. Convertisseur de fréquence selon la revendication 2, **caractérisé en ce que** le ventilateur (34) est disposé dans la zone de déviation d'air (41).

4. Convertisseur de fréquence selon l'une quelconque des revendications 1 à 3, **caractérisé en ce que** le troisième profilé annulaire (48) pour la formation d'un corps de refroidissement se compose d'une bague extérieure (49) et d'une bague intérieure (54), des nervures de refroidissement (50, 52) formant une paroi de l'un des espaces annulaires (56) servant de canal d'air de refroidissement étant disposées dans la zone située entre la bague extérieure et la bague intérieure.

5. Convertisseur de fréquence selon la revendication 4, **caractérisé en ce qu'**une partie (52) des nervures de refroidissement relie entre elles la bague extérieure et la bague intérieure (49, 54) et des nervures (50) faisant saillie librement vers l'intérieur dans le sens radial sont disposées entre ces nervures de refroidissement (52) sur la bague extérieure (49).

6. Convertisseur de fréquence selon l'une quelconque des revendications 1 à 5, **caractérisé en ce que** le premier profilé annulaire (16) extérieur est en prise avec le profilé annulaire (36) voisin selon le principe de rainure-languette (42, 44).

7. Convertisseur de fréquence selon l'une quelconque des revendications 1 à 6, **caractérisé en ce que** l'espace du transformateur (38) peut être fermé dans le sens axial par des couvercles (46, 47) de forme annulaire, s'étendant entre la délimitation extérieure par le second profilé annulaire (36) et la délimitation intérieure par le troisième profilé annulaire (48) de l'espace du transformateur.

8. Convertisseur de fréquence selon l'une quelconque des revendications 1 à 7, **caractérisé en ce que** l'espace de transformateur (38) contient un ensemble de transformateur toroïdal (60a, 60b, 60c).

9. Convertisseur de fréquence selon l'une quelconque des revendications 1 à 8, **caractérisé en ce que** les profilés annulaires sont des profilés extrudés.

10. Convertisseur de fréquence selon la revendication 9, **caractérisé en ce que** les profilés extrudés (16, 36, 48) sont des profilés filés d'aluminium coupés à la longueur adaptée.

11. Convertisseur de fréquence selon la revendication 1, **caractérisé en ce que** le premier profilé annulaire (16) extérieur est relié de façon centrée au logement du convertisseur (14).

12. Convertisseur de fréquence selon l'une quelconque des revendications 1 à 11, **caractérisé en ce que** le logement du convertisseur (14) est constitué essentiellement d'une pièce moulée d'aluminium.

13. Convertisseur de fréquence selon l'une quelconque des revendications 1 à 12, **caractérisé en ce que** le troisième profilé annulaire (48) est centré par les couvercles (46, 47) fermant l'espace du transformateur (38) par rapport au second profilé annulaire (36) voisin du premier profilé annulaire (16).

14. Convertisseur de fréquence selon la revendication 2, **caractérisé en ce que** le ventilateur (34) est conçu de telle sorte qu'il aspire de l'air de refroidissement par le canal d'air de refroidissement (40) voisin du premier profilé annulaire (16) extérieur et évacue cet air à nouveau vers l'extérieur par le canal d'air de refroidissement (56) entouré par l'espace du transformateur (38).

15. Convertisseur de fréquence selon l'une quelconque des revendications 1 à 14, **caractérisé en ce que** la zone de refroidissement (30) est fermée dans le sens axial d'une part par la paroi de séparation (31) du logement de convertisseur (14) et d'autre part par un couvercle (18) doté d'ouvertures de passage d'air (21).

16. Convertisseur de fréquence selon l'une quelconque des revendications 1 à 15, **caractérisé en ce que** l'espace de platine (28) est fermé d'une part par la paroi de séparation (31) du logement de convertisseur (14) et d'autre part par une platine avant (22).

17. Convertisseur de fréquence selon l'une quelconque des revendications 1 à 16, **caractérisé en ce qu'**une platine de convertisseur (32) logée dans l'espace de platine est scellée avec un module de puissance et peut être échangée.
